# EUROPEAN PATENT APPLICATION

(11) **EP 4 841 232 A2**
(43) Date of publication of application: **18.11.2026**
(21) Application number: 26172624.4
(22) Date of filing: 16.04.2026
(51) Int. Cl.: G01M 5/00, B33Y 80/00, B81B 5/00, G01L 1/14

(54) **3D PRINTED STRUCTURE WITH INTEGRAL SENSOR**

(30) Priority: 16.05.2025 GB 202507560
(71) Applicant: Rolls-Royce plc, London N1 9FX (GB)
(72) Inventor: Gameros Madrigal, Andres A., Derby, DE24 8BJ (GB); Xie, Caoyu, Derby, DE24 8BJ (GB); Mohammad, Abdelkhalick, Derby, DE24 8BJ (GB); Axinte, Dragos A., Derby, DE24 8BJ (GB)
(74) Representative: Rolls-Royce plc

(57) **Abstract**

A component manufactured by an additive manufacturing process comprises conductive (34) and non-conductive (30) elements. The conductive and non-conductive elements cooperate to form a capacitor which in use responds to an external stimulus (36).

## Description

### CROSS REFERENCE TO RELATED APPLICATIONS

This represents the first application directed towards the subject-matter.

### FIELD

This disclosure relates to monitoring of installations using sensors.

### BACKGROUND

The digitalisation and real-time monitoring of installations represent significant challenges in today's industries, particularly in aerospace, where the collection of diverse data from various sensors throughout the aircraft, especially on the engine, is essential. These data encompass critical parameters such as vibration, mass flows, fuel properties, exhaust gas composition, and gas path debris. Leveraging advanced cloud-based computation and storage, a digitally enabled aircraft can utilise this information for purposes such as predictive analyses, facilitating trend anticipation, outcome prediction, and behavioral model analyses, which can in turn facilitate cost saving, product improvement, and quality optimization. Furthermore, real-time data acquisition and processing enable instantaneous decision-making, aimed at leveraging data more effectively beyond individual capabilities.

However, at the hardware level, the current state of the art imposes limitations. Off-the-shelf attached sensing systems, while widely used, present drawbacks such as increased component size, reduced integration, and cumbersome motion of certain mechanisms. Additionally, ensuring the resilience of sensing units in hostile environments is a major challenge. Deploying sensors exposed to these harsh conditions often necessitates the use of exotic materials or expensive alloys. Alternatively, common silicon-based sensors may not be suitable for integrated manufacturing of structures.

The optimization of communication connections among sensors and central control is an ongoing concern. General methods include wireless sensors and distributing the Full Authority Digital Engine Control (FADEC) in separate parts to minimize wiring for sensor interaction. Effective wire management can enhance the reliability of attached sensors, though inter-sensor wire links must be carefully maintained. Wireless sensors, however, present different challenges related to power supply and transmission reliability.

Most structural health tests are currently conducted on the ground, utilizing techniques such as eddy current detection and Comparative Vacuum Monitoring (CVM), which supplement visual inspections to streamline maintenance procedures and save time. However, the integration of structural health inspection tools into in-flight structural health monitoring systems, and their optimal application to different structures, remain challenging.

### SUMMARY

According to a first aspect, a component manufactured by an additive manufacturing process comprises conductive and non-conductive elements, the conductive and non-conductive elements cooperating to form a capacitor which in use responds to an external stimulus.

The conductive and non-conductive elements may form a cell.

The cell may contribute to the mechanical strength of the component.

The capacitor may comprise two spaced-apart conductive elements, and the capacitor may respond to the external stimulus by a change in the distance between the conductive elements.

The capacitor may comprise two spaced-apart conductive elements, and the capacitor may respond to the external stimulus by a change in the area of overlap between the conductive elements.

The external stimulus may be one selected from the list comprising: vibration; acceleration; moisture level; deformation.

The cell may comprise a centre cell wall, and the centre cell wall may act in use as a beam-mass structure.

The first resonance mode of the beam-mass structure may be a twisting mode.

The conductive elements forming the capacitor may be curved.

The component may further comprise integrated conduction paths manufactured by an additive manufacture process.

According to a second aspect, a component manufactured by an additive manufacturing process comprises conductive and non-conductive elements, the component comprising a plurality of conduction channels, the conduction channels arranged so that in use their electrical properties will change in response to damage within the component.

The plurality of conduction channels may be arranged in a 3-dimensional lattice, and a change in the electrical properties of two or more adjacent conduction channels may permit the location of damage to be determined.

According to a third aspect, a method of manufacturing a component by an additive manufacturing process comprises disposing conductive and non-conductive elements to form a capacitor which in use can respond to an external stimulus.

According to a fourth aspect, a method of manufacturing a component by an additive manufacturing process comprises disposing conductive and non-conductive elements to form a plurality of conduction channels, the conduction channels arranged so that in use their electrical properties will change in response to damage within the component.

The plurality of conduction channels may be arranged in a 3-dimensional lattice, so that in use a change in the electrical properties of two or more adjacent conduction channels will permit the location of damage to be determined.

### BRIEF DESCRIPTION OF THE DRAWINGS

Embodiments will now be described by way of example only with reference to the accompanying drawings, in which:
FIG. 1 is a sectional side view of a gas turbine engine;
FIG. 2A shows an embodiment of part of a cellular structure of a large metamaterial lattice printed by additive manufacturing technology;
FIG. 2B shows an embodiment of part of a cellular structure of a large metamaterial lattice printed by additive manufacturing technology;
FIG. 2C shows part of FIG. 2A in more detail;
FIG. 2D shows part of FIG. 2B in more detail;
FIG. 3A shows two adjacent functional cells;
FIG. 3B shows an embodiment of an accelerometer;
FIG. 3C is an alternative view of the accelerometer of FIG. 3B;
FIG. 4A shows an embodiment of a beam-mass structure;
FIG. 4B shows an embodiment of a beam-mass structure;
FIG. 4C shows an embodiment of a beam-mass structure;
FIG. 4D shows an embodiment of an accelerometer;
FIG. 5 shows an embodiment of an beam-mass structure;
FIG. 6A is an upper view of an embodiment of an accelerometer;
FIG. 6B is a front view of an embodiment of an accelerometer;
FIG. 6C is a sectional view on the line A-A of FIG. 6A;
FIG. 6D is a sectional view on the line B-B of FIG. 6B;
FIG. 6E is a schematic illustration of a measurement system including an accelerometer;
FIG. 7A is a cross-section through a layer of a 3D-printed structure; and
FIG. 7B shows a 3D-printed structure of which FIG. 7A represents a single layer.

### DETAILED DESCRIPTION

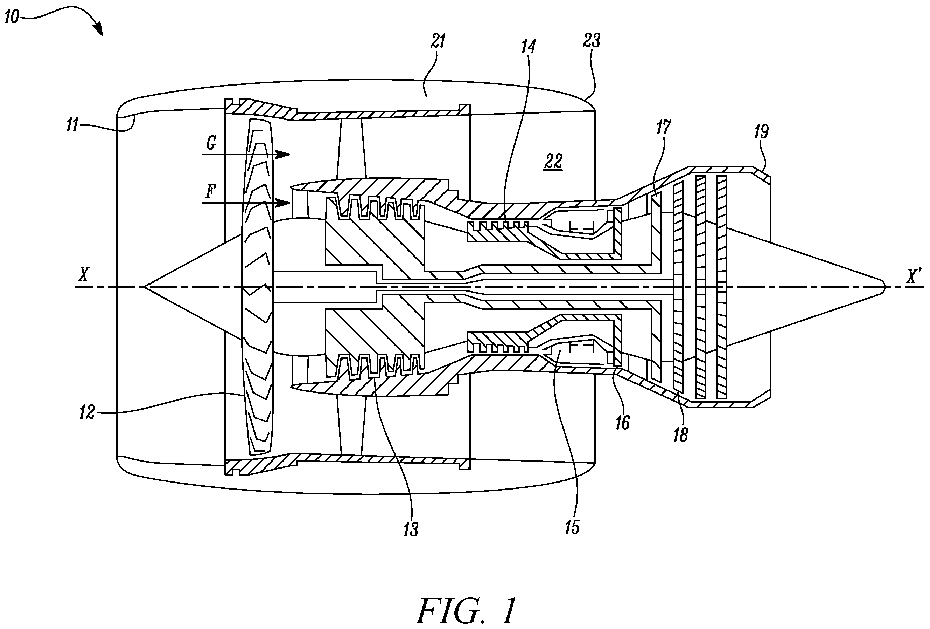

**FIG. 1** shows a schematic sectional side view of a gas turbine engine 10 having a principal rotational axis X-X'. The gas turbine engine 10 includes, in axial flow series, an air intake 11, a compressive fan 12 (which may also be referred to as a low pressure compressor), an intermediate pressure compressor 13, a high pressure compressor 14, combustion equipment 15, a high pressure turbine 16, an intermediate pressure turbine 17, a low pressure turbine 18, and a core exhaust nozzle 19. A nacelle 21 generally surrounds the gas turbine engine 10 and defines the air intake 11, a bypass duct 22, and a bypass exhaust nozzle 23.

The gas turbine engine 10 works in a conventional manner so that the air entering the air intake 11 is accelerated by the compressive fan 12 to produce two air flows: a first air flow F into the intermediate pressure compressor 13, and a second air flow G which passes through the bypass duct 22 to provide a propulsive thrust. The intermediate pressure compressor 13 compresses the first air flow F directed into it before delivering that air to the high pressure compressor 14 where further compression takes place.

The compressed air exhausted from the high pressure compressor 14 is directed into the combustion equipment 15 where it is mixed with fuel and the mixture is combusted. The resulting hot combustion products then expand through, and thereby drive the high, intermediate, and low pressure turbines 16, 17, 18 before being exhausted through the core exhaust nozzle 19 to provide additional propulsive thrust. The high, intermediate, and low pressure turbines 16, 17, 18 respectively drive the high and intermediate pressure compressors 14, 13, and the compressive fan 12 by suitable interconnecting shafts.

In some embodiments, the gas turbine engine 10 is used in an aircraft. In some embodiments, the gas turbine engine 10 is an ultra-high bypass ratio engine (UHBPR). In addition, the present invention is equally applicable to other aero gas turbine engines, marine gas turbine engines, and land-based gas turbine engines.

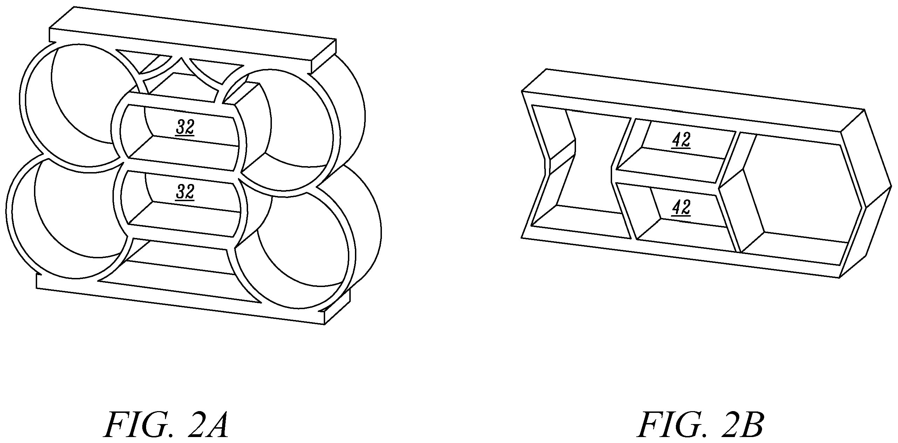

**FIG. 2A** and **FIG. 2B** show alternative embodiments of parts of a cellular structure of a large metamaterial lattice printed by additive manufacturing technology. Cells 32, 42 are functional cells or functional units embedded in the local lattice, whose purpose will be described in more detail below. It will be appreciated that many different arrangements of the cells within the lattice, and many different combinations and forms of the functional units, are possible, and FIG. 2A and FIG. 2B are intended only as conceptual illustrations. The exact configuration of any particular metamaterial lattice will depend on the mechanical properties required of it.

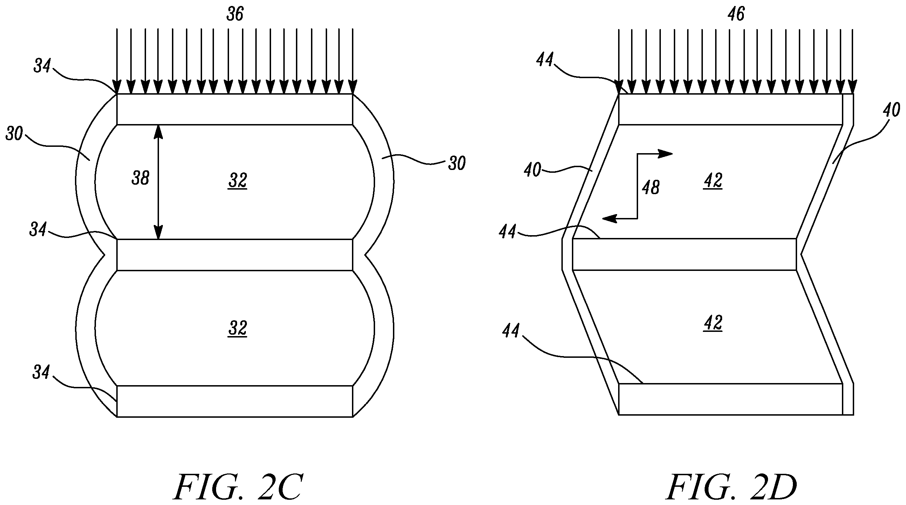

**FIG. 2C** shows in more detail the functional cells 32 of FIG. 2A. Cell walls 30, 34 define and enclose cells 32. For clarity, only two cells 32 are shown; it will be appreciated that the structure may comprise any number of such cells. Cell walls 30 are formed from a suitable non-conductive material, while cell walls 34 are formed of a conductive material. Cell walls 34 are parallel to one another and spaced apart, so that each pair of cell walls 34 at the top and bottom of a respective cell 32 will form a two-plate capacitor; this capacitor can be connected via suitable wires (not shown) to a suitable processing module (not shown). The processing module may be, for example, a capacitance evaluation module or an edge processing module. The processing module may be, or may be a part of, a central control module or an external measurement module The cell walls 30 of FIG. 2A are configured so that when an external force 36 acts upon the structure, the cell walls 30 will buckle in a repeatable and reversible manner, thereby altering the distance 38 between the respective cell walls 34. The change in the distance 38 will change the capacitance measured between the respective cell walls 34. The physical characteristics of the cell walls 30 (for example: material, wall thickness, radius of curvature) are configured to provide a desired response (for example, rate of deformation) to the external force 36.

The external force 36 may be a static force or a dynamic force (e.g. a vibration), or a combination of the two.

**FIG. 2D** shows in more detail the functional cells 42 of FIG. 2B. Cell walls 40, 44 define and enclose cells 42. For clarity, only two cells 42 are shown; it will be appreciated that the structure may comprise any number of such cells. Cell walls 40 are formed from a suitable non-conductive material, while cell walls 44 are formed of a conductive material. Cell walls 44 are parallel to one another and spaced apart, so that each pair of cell walls 44 at the top and bottom of a respective cell 42 will form a two-plate capacitor; this capacitor can be connected via suitable wires (not shown) to a suitable processing module (not shown). As above, the processing module may be, for example, a capacitance evaluation module or an edge processing module. In contrast to the structure of FIG. 2A, the structure of FIG. 2B is configured so that when an external force 46 acts upon the structure, the cell walls 40 will deflect causing cells 42 to adopt a different shape, thereby altering the area of overlap between respective cell walls 44 of each cell (as indicated by arrow 48). The change in the overlap area will change the capacitance measured between the respective cell walls 44. The physical characteristics of the cell walls 40 (for example: material, wall thickness, angle between cell walls 40 and 44, geometry of vertices between cell walls 40 and 44) are configured to provide a desired response (for example, rate of deformation) to the external force 46.

The external force 46 may be a static force or a dynamic force (e.g. a vibration), or a combination of the two.

In FIG. 2C, the deformation is attributed to buckling instabilities, where the structural cells collapse in a predictable pattern when subjected to compressive stress. Conversely, FIG. 2D depicts cell reconfiguration, where cells adapt and rearrange their structure dynamically in response to external forces.

These distinct deformation modes emphasize the versatility of the functional cells' response to mechanical stimuli, achieved through geometrical preconditioning. For example, tuning the thickness or pre-shaping the geometry of cell walls 30, 40 can precisely control whether a structure undergoes controlled collapse (buckling) or flexible adaptation (reconfiguration). These design strategies enable the tailoring of deformation behavior for different sensing principles (capacitance due to two-plate's overlay area or distance change), and meet requirements for specific applications, such as energy absorption, vibration damping, or structural stability enhancement.

It will be appreciated that the behavior of the cells 32, 42 under the external force 36, 46 will not be controlled solely by the configuration of the cells 32, 42 themselves (as described in the paragraphs above) but will also be influenced by the surrounding structure as shown in FIG. 2A and FIG 2B. By suitable design of the entire metamaterial lattice, and by positioning the functional cells 32, 42 at suitably selected critical positions within it, the deflection of the functional cells 32, 42 can therefore be arranged to monitor the deflection of the entire metamaterial lattice. It will be appreciated that the terms "functional cell" and "functional unit" are used to distinguish those cells that are configured to perform an additional function within the metamaterial (such as cells 32, 42 that incorporate capacitors) from the other cells of the cellular structure, as shown for example in FIG. 2A and FIG. 2B.

While a cellular structure such as those shown in FIG. 2A or FIG. 2B is being printed by an additive manufacturing technique, as described above, the cells 32, 42 may be filled by air; this air will therefore form the dielectric medium of the capacitors formed by the respective pairs of cell walls 34, 44. Alternatively, the additive manufacturing technique may be configured to fill the cells 32, 42 partly or fully with a different material, in which case that different material will form the dielectric medium. The different dielectric properties of such an alternative filling material may permit the response of the functional cells 32, 42 to be better optimized for particular purposes.

It will be appreciated that providing a solid dielectric medium within a cell 32, 42 may limit the ability of the cell 32, 42 to deform in response to an external force 36, 46, and this would have to be considered in the design of the cellular structure. If a certain deflection of the cell 32, 42 is required in response to the external force 36, 46, so that that deflection results in a desired change in capacitance and therefore in the generated signal, then it may still be possible to control the dielectric medium to change the permittivity of the capacitor, for example by retaining the air-filled gaps left by the normal printing process, or by designing a closed cavity within cells 32, 42 into which a selected gas or liquid dielectric medium may be injected.

When printing cellular structures such as those shown in FIG. 2A or FIG. 2B, other cells besides the functional cells 32, 42 may also be filled partly or fully by a different material. This may provide another means by which the mechanical properties of the entire metamaterial lattice may be configured to meet particular requirements.

Alternatively or additionally, a cellular structure may be printed by an additive manufacturing technique, as described above, and subsequently one or more cells may be filled with a different material in a separate process. Such a process may facilitate the filling of cells with a gas or liquid, which would not be possible in an additive manufacturing process.

At the same time, in the design of specific metamaterial lattice structures, certain fixed, non-deformable cells can be retained as dual-plate capacitors. Since the electrode positions remain fixed, any changes in the dielectric medium between the plates - caused, for example, by environmental variations such as humidity fluctuations or shifts in the medium composition - will alter the permittivity, thereby leading to capacitance changes. By monitoring these capacitance variations, it is possible to detect and track changes in the surrounding environment of the lattice, including humidity levels and alterations in the dielectric medium.

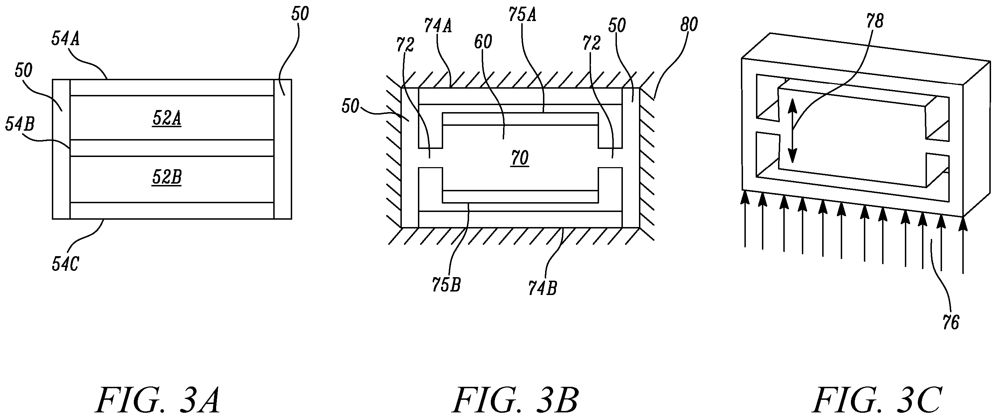

**FIG. 3A** shows two adjacent functional cells 52A, 52B constructed in a similar manner to the cells shown in FIG. 2C and FIG. 2D. Cell walls 50 are formed of a non-conductive material. Cell walls 54A, 54B are formed of a conductive material and will therefore form a two-plate capacitor. Cell wall 54C is likewise formed of a conductive material and will therefore form a two-plate capacitor together with cell wall 54B. As described above, these two capacitors (54A, 54B and 54B, 54C) may be connected via suitable wires (not shown) to a suitable processing module (not shown).

The inventors have identified that the arrangement of FIG. 3A may be modified to create a printable accelerometer. In **FIG. 3B****,** the central cell wall 54B of FIG. 3A is enlarged into a beam-mass structure 60, in which a central mass 70 is connected to cell walls 50 via two beams 72, thereby creating a spring-mass-damper system. The central mass 70 is formed of a non-conductive material. Both the upper 75A and lower 75B surfaces of the central mass 70 are formed of a conductive material, so that each of the surfaces 75A, 75B together with, respectively, the upper 74A and lower 74B cell walls will form a two-plate capacitor. Cell wall 74A and surface 75A are parallel and spaced apart, as are surface 75B and cell wall 74B.

As shown in **FIG. 3C****,** when the beam-mass structure 60 is subjected to an external force (which in this instance is a vibration 76), it is stimulated and reacts (as shown by the arrow 78), generating a distinctive response signal pattern in the two capacitors (74A, 75A and 75B, 74B).The dual two-plate capacitors, or their associated processing module, can employ a differential measuring method and algorithm to mitigate surrounding electromagnetic interference during capacitance measurement. This approach helps compensate for the absence of sensor shield packaging, enhancing the reliability and accuracy of the measurement process.

To ensure that changes in the distance between the two plates result solely from the shaking of the beam-mass structure corresponding to external vibration input, a rigid mechanical structure (80 in FIG. 3B) surrounds the accelerometer. In the embodiment illustrated in FIG. 3B and FIG. 3C, the overlap area of the capacitors remains constant, allowing monitoring of capacitance to capture instant displacement changes of the mass. This displacement signal, in conjunction with the characterized mechanical properties of the beam-mass structure, facilitates the conversion to required acceleration data. By suitable design of the central mass 70 and beams 72, higher order vibrations and twist modes may be suppressed, so that the response of the beam-mass structure to external vibration is a simple up-down vibration.

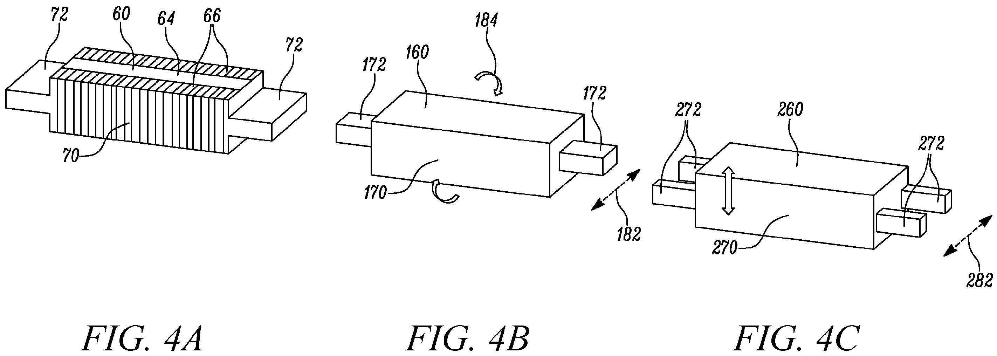

**FIG. 4A, FIG. 4B, and FIG. 4C** illustrate enhancements of the embodiment of FIG. 3B, in which the mass distribution of the beam-mass structure is optimized. This optimization can, for example, include designing the beam geometries to control the modes of vibration and focus on different excitation properties to unlock various potentials of the sensing elements. For example, increasing the printing density in specific areas or adjusting the beam width can shift the twisting mode to become the primary resonance mode. Alternatively, adding more beams to redistribute the beam stiffness away from the central axis can help mitigate twisting effects. These design modifications enhance the structural response and expand the functional capabilities of the sensing system.

FIG. 4A shows a beam-mass structure 60, comprising a central mass 70 and two beams 72. The central mass 70 comprises a central region 64 and two peripheral regions 66 (indicated by hatching). The printing density of the peripheral regions 66 may be different from the printing density of the central region 64; for example, increasing the printing density, and therefore the mass, of the peripheral regions 66 relative to the central region 64 will make the structure more prone to twisting, whereas reducing the printing density will have the opposite effect.

FIG. 4B shows a beam-mass structure 160, comprising a central mass 170 and two beams 172. The central mass 170 may be of uniform density, as in the embodiment of FIG. 3B, or its density may be tailored as described above in relation to FIG. 4A. Unlike the embodiment of FIG. 4A, the beams 172 do not extend across the whole width (direction 182 in FIG. 4B) of the central mass 170, but are narrower than the central mass 170. This configuration makes the beam more prone to twisting in direction 184, and thereby makes the first resonance mode a twisting mode. Fine-tuning the primary resonance mode would require a more sophisticated design of both the central mass and beam structure, considering material properties and geometric configurations. However, from a qualitative perspective, FIG. 4A and 4B demonstrate the feasibility of controlling the beam-mass motion through structural modifications, such as adjusting the beam dimensions and the internal density distribution of the central mass.

FIG. 4C shows a beam-mass structure 260. As in the embodiment of FIG. 4B, the central mass 270 may be of uniform density, as in the embodiment of FIG. 3B, or its density may be tailored as described above in relation to FIG. 4A. In this embodiment two pairs of beams 272, one pair at each end of the central mass 270, are provided to connect the central mass 270 to surrounding structure (not shown)..The respective pairs of beams 272 are spaced apart in the width direction 282, so that they primarily reinforce the stiffness at the edges. This beam configuration helps prevent twisting of the central mass 270 when subjected to external loads or vibrations.

The embodiments shown in FIGS. 3A, 3B, 3C, 4A, 4B, 4C and described above provide embedded accelerometers, which can be manufactured as part of a larger cellular structure by an additive manufacturing method, and which can provide output signals in response to external forces, vibrations, or accelerations which are applied in a specific direction. By combining accelerometers oriented in different directions (e.g., sensing along the x- and z-axes), a multi-dimensional sensing capability can be provided within the cellular structure.

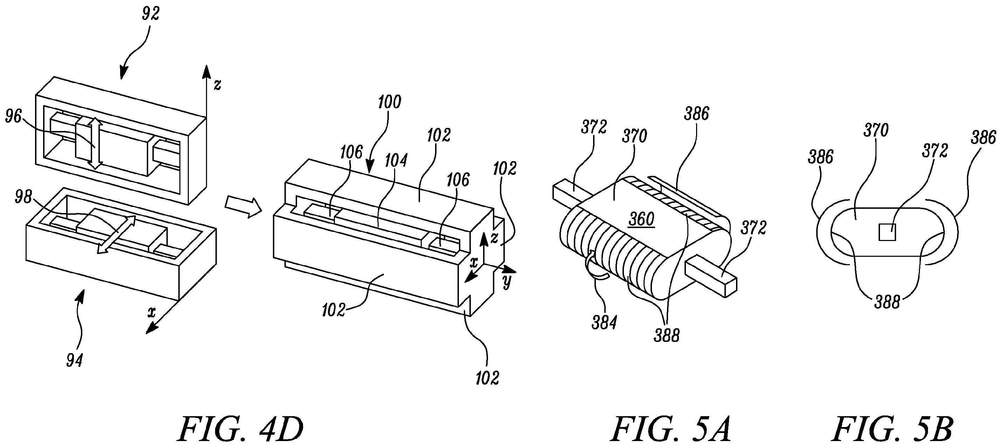

In the left-hand part of **FIG. 4D****,** two separate accelerometers 92, 94 of similar configuration to those shown in FIG. 3C are oriented perpendicular to each other, so that accelerometer 92 will respond to external forces in the z direction and accelerometer 94 will respond to external forces in the x direction (as indicated by the respective arrows 96, 98. In the right-hand part of FIG. 4D, the functionality of the separate accelerometers 92, 94 has been combined into a single accelerometer 100, in which the four cell walls 102 cooperate with four respective surfaces of the central mass 104 to form two pairs of capacitors, one pair oriented in the z direction and one in the x direction. The dimensions of the beams 106 in the z and x directions will be selected to give the desired response to external forces in those two directions.

**FIG. 5A and FIG. 5B** show two views of an embodiment of an accelerometer. Similarly to the embodiment of FIG. 4B, a beam-mass structure (360 in FIG. 5A) comprises a central mass 370 and two narrowed beams 372 aligned with a centre line of the central mass 370, so that the first resonance mode of the beam-mass structure is a twisting mode (as shown by the arrow 384 in FIG. 5A). In contrast to the beam-mass structure of FIG. 4B, the central mass 370 has curved side portions 388 formed of conductive material. Corresponding curved conductive electrodes 386 (only one shown in FIG. 5A for clarity) are located on the structure (not shown) surrounding the beam-mass structure 360, so that the curved conductive electrodes 386 are parallel with, and spaced apart from, the curved side portions 388 of the central mass 370. The respective curved electrodes 386 and curved side portions 388 therefore form a pair of two-plate capacitors. In use, when the beam-mass structure responds to an applied force or vibration by twisting, the area of overlap between the curved electrodes 386 and the curved side portions 388 will change. The resulting change in capacitance can be detected and analysed.

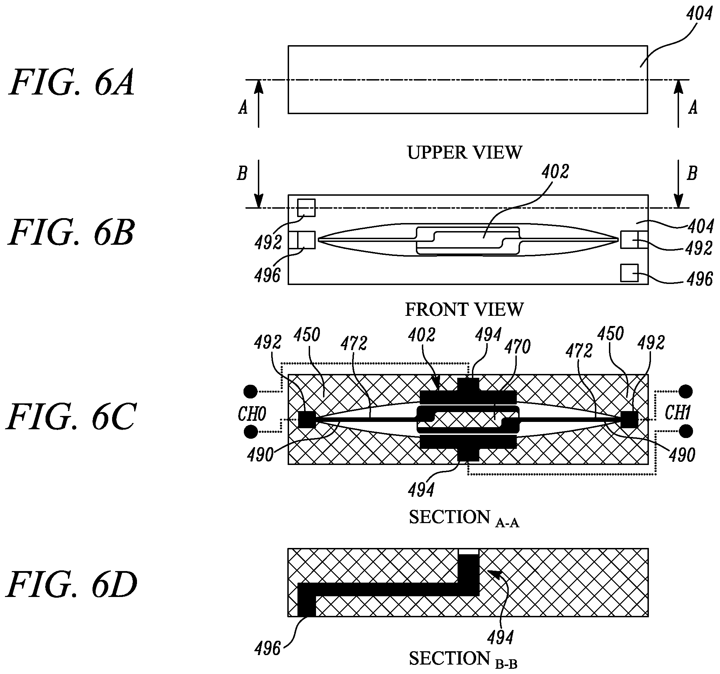

In an embodiment, communication between embedded sensors (such as those described above) and a central control module can be enhanced by using additive manufacture techniques to improve wire management associated with the sensors. **FIG. 6A** and **FIG. 6B** are, respectively, upper and front views of an embedded accelerometer 402 formed by an additive manufacture technique and embedded within a structure 404.

**FIG. 6C** is a sectional view on the line A-A in FIG. 6A. Accelerometer 402 is of a similar configuration to the accelerometer shown in FIG. 3B and described above, comprising a beam-mass structure (60 in FIG. 3B), in which a central mass (470 in FIG. 6C) is connected to cell walls 450 via two beams 472, thereby creating a spring-mass-damper system. The central mass 470 is formed of a non-conductive material (indicated by the crosshatched area in FIG. 6C). Both the upper and lower surfaces of the central mass 470 are formed of a conductive material (indicated in solid black), so that each of those upper and lower surfaces together with the respective upper and lower cell walls (also formed of conductive material, indicated in solid black) will form a two-plate capacitor. As in the arrangement of FIG. 3B, the respective cell walls and surfaces are parallel and spaced apart. In the arrangement of FIG. 6C, further conductive material 490 is printed along each of the beams 472, forming a conduction path between the respective upper and lower surfaces of the central mass 470 and corresponding electrical contacts 492 on the outside of the cell walls 450. In use, suitable electrical wiring can be connected to these contacts 492. Alternatively, the printed conduction paths can be extended further beyond the outside of the cell walls 450, to suitable positions elsewhere on the integrated structure, and then connected to the external measurement module.

In a similar manner and as shown more clearly in **FIG.** 6D, further conductive material 494 is printed within the cell walls 450, forming a conduction path between the respective upper and lower cell walls and corresponding electrical contacts 496 on the outside of the cell walls 450. In use, suitable electrical wiring can be connected to these contacts 496.

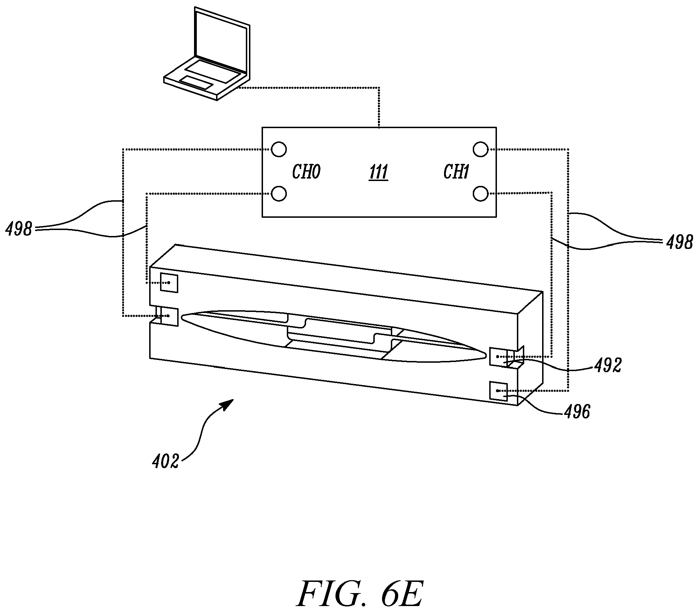

As shown in **FIG. 6E****,** the capacitance signals from the two capacitors of the accelerometer 402 can thereby be fed via respective electrical contacts 492, 496 (as shown also in FIG. 6B) and suitable wiring 498 to a central control module 111, and variations in the signals can be separately detected (as indicated by CH0, CH1) and analysed.

The arrangements shown in FIG. 6A-E effectively address challenges associated with peripheral sensor-to-centre communication (for example: cable management; communication integration; and optimizing multi-material, additively-manufactured circuit design) by integrating electrical connection routes within the structure. This approach streamlines communication pathways, and at the same time, the conjugate dual-capacitor matching structure provides hardware structure support for differential measurement of the movement and position of the central mass block (470 in FIG.6C), further enhancing the functionality of the cognitive structure design.

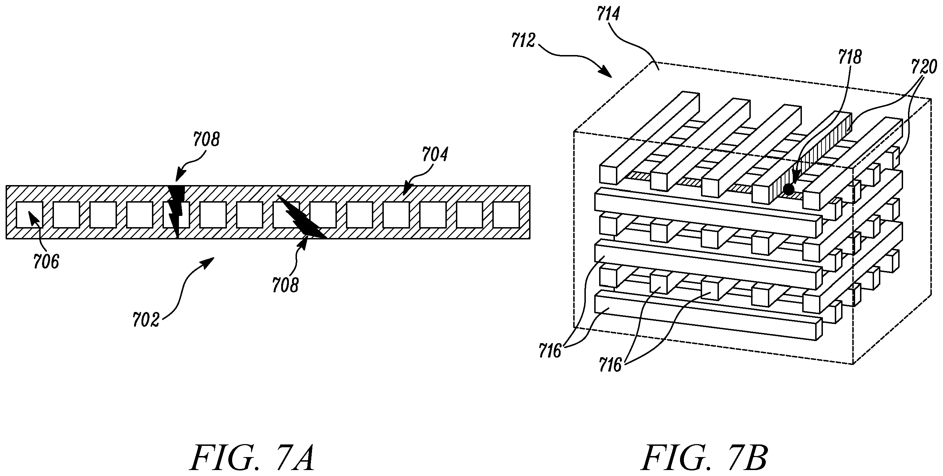

In a further arrangement, illustrated in **FIG. 7A** and **FIG. 7B****,** the provision and use of printed cognitive structures allows a structure health monitor system to be embedded directly inside a critical inspection location. FIG. 7A shows a cross-section through a layer of a 3D-printed structure 702 formed of non-conductive material 704 (indicated by hatching). Embedded within the non-conductive material 704 are a plurality of conduction channels 706 formed of conductive material. The conduction channels 706 may be formed during the same 3D printing process as the rest of the structure 702. The conduction channels 706 extend in a direction perpendicular to the plane of FIG. 7A.

As is well known, structures may sustain damage during manufacture or in use. Conventional methods for detecting and quantifying such damage have limitations. External inspection techniques can only detent damage that extends to an outer surface of the structure and cannot quantify the extent of the damage within the structure. Known nondestructive inspection techniques require sizeable, specialised equipment and may require removal or disassembly of the structure.

FIG. 7A shows examples of damage in the form of cracks 708, which extend through both the non-conductive material 704 and some of the conduction channels 706. Where a crack 708 extends through a conduction channel 706 it will disrupt the electrical conductivity of the conduction channel 706, by reducing the cross-sectional area of the conduction channel 706 and thereby increasing its electrical resistance. In an extreme case, the crack 708 may completely sever the conduction channel 706. The presence and extent of such cracking may therefore be measured by passing an electrical current through the conduction channels 706. A crack may be identified by detecting a difference between the actual electrical properties of the conduction channels 706 and their expected electrical properties, for example to identify a crack arising during a manufacturing process. Alternatively, the electrical properties of the conduction channels 706 may be monitored over time, with changes in the electrical properties indicating new or increasing damage within the structure 702.

Figure 7B shows a larger 3D-printed structure 712, of which the structure 702 of FIG. 7A represents a single layer. As with the structure 702, the structure 712 is formed of non-conductive material 714 (indicated by the dotted box). Embedded within the non-conductive material 714 are a plurality of conduction channels 716 formed of conductive material. The conduction channels 716 may be formed during the same 3D printing process as the rest of the structure 712. The conduction channels 716 are arranged in layers, with adjacent layers being mutually perpendicular, to form a 3-dimensional lattice extending throughout the structure 712.

In use, electrical currents are passed through the conduction channels 716 in the same way as in the arrangement of FIG. 7A. Location 718 indicates a position where damage has occurred within the structure 712, for example a crack like that shown by 708 in FIG. 7A. As shown in FIG. 7A, the damage 718 disrupts the electrical conductivity of the two adjacent conduction channels 720 (hatched). By detecting which two conduction channels 720, out of the plurality of conduction channels 716, have disrupted electrical conductivity, it is possible to identify the specific area that is damaged. One suitable method for identifying a damaged area is as follows. Each conduction channel 716 may be individually addressable at its terminal ends, which are accessible from the exterior of the structure. A multiplexer or switching matrix may be employed to sequentially connect pairs or sets of conduction channels to a measurement unit. Electrical resistance measurements (e.g., via four-wire sensing or simpler two-point resistance measurements) may be performed by passing a known current through a conduction channel and measuring the resulting voltage drop. Disruption caused by a crack will manifest as an increased resistance or an open circuit condition in one or more conduction channels. By systematically scanning the conduction lattice in orthogonal directions - X-layer channels and Y-layer channels - the intersection point of two affected channels indicates the spatial location of the damage within the structure. Optionally, automated software may be used to record and visualize these resistance anomalies for real-time structural health monitoring.

In contrast to known methods, this arrangement permits damage to be detected and accurately located in real time and inside a structure, even when no damage is visible from the outside of the structure. This integrated framework design serves as an embedded health monitoring system for critical structures, providing a solution for early-stage inspection of minor damage. For instance, such lattice-based internal monitoring is beneficial in applications such as composite engine casings, high-load structural frames, or load-bearing jigs in aerospace settings, where early detection of micro-damage or material fatigue is critical to ensure operational safety and extend service life.

The unifying concept in the arrangements described above lies in the integration of sensing units as various modules (functional cells or functional units) into the macroscale structure, thereby creating a cognitive metamaterial within a single manufacturing process. This eliminates the necessity for attaching sensors separately and allows the making of structures that can self-monitor their integrity. The functional cells within the structure act both as load-bearing members, contributing to the overall mechanical properties of the structure, but also as active sensing units. This integration not only streamlines the manufacturing process but also enhances overall efficiency by facilitating seamless integration of sensing functionalities into the structure.

The arrangements described above collectively present a novel approach to the development of cognitive structures by utilizing 3D printing methods to manufacture workpieces with embedded sensing units, eliminating the need for off-the-shelf elements. Leveraging multi-material printing, including conductive filament, capacitive sensing elements are printed and embedded into lattice frameworks for displacement sensing or cellular shear monitoring within the structure. This approach offers significant design flexibility in mechanical aspects, allowing for adjustments to buckling instabilities and reconfigurability.

Furthermore, the same capacitor-based principle is employed to achieve complex functions for acceleration/vibration sensing, utilizing the beam-mass system as the core. Tailoring designs of the beam and mass allow for control over vibration modes and enables various applications. Introducing conductive materials into the 3D printing process enables the sensing unit to be integrated as part of the overall structure, eliminating the need for external wiring and enhancing space-saving and integration ratios.

By directly obtaining sensing signals from the structure itself, lattice sensing elements placed in critical locations can provide in-flight operational maintenance or diagnosis monitoring for framework health inspection, without requiring additional devices that could affect mechanical features or internal communications.

These techniques allow integration of all functions, connections, and inspections within the computer-aided design process, followed by one-time printing of prototypes. This concept not only ensures that the structure retains its mechanical functions but also enables functional units to be easily deployed in 'hard-to-reach' monitoring locations. Additionally, depending on the conductive filaments used (e.g., metal printing), the sensing unit could withstand extreme environments in future applications, such as high-temperature chambers in aero-engines.

A similar concept can be extended to monitor other environmental conditions, such as moisture ingress, using the same capacitive sensing principle. Moisture monitoring is particularly critical for safety in 3D-printed structural components, especially those designed to support loads - such as lifting tools, fixtures, or jigs. It is known that plastic-based 3D-printed components may absorb moisture over time, which can degrade their mechanical properties and lead to dimensional changes or structural deformation. By embedding capacitive elements sensitive to dielectric property changes, early detection of moisture-induced performance shifts can be achieved.

The integration of electrically conductive routes can also be implemented to perform simple binary operations within the structure. As an example, the structure of FIG. 7A could be connected to a LED that communicates a good state. As the channel breaks, the current will be suspended, thus turning the LED off and denoting that the system is no longer safe to be used.

In the described examples, sensing and actuating systems are integrated into the framework of a structure. Additive manufacturing techniques permit the creation of cellular designs that incorporate mechanical units with built-in monitoring and control functions, enabling self-response to external stimuli. Furthermore, the communication connections among sensors and between sensors and control or monitoring systems can be embedded into the structures using the same additive manufacturing techniques.

Unlike conventional fabrication methods, which often involve manually adding sensing parts by attaching electrodes or applying conductive printing or ink, the use of conducive and non-conductive materials in these structures permits the creation of interactive sensing structures seamlessly integrated into a component. These structures serve a dual purpose, providing mechanical support to the structure while also monitoring post-setting deformation, such as pressure loads, moisture, and surface shearing, at the macroscale.

Considered together, the arrangements described above overcome limitations of conventional sensor arrangements by directly embedding sensing functionalities into the structural lattice during the additive manufacturing process. This approach eliminates the need for separate attachment of sensors, reduces manufacturing complexity, improves sensor robustness in harsh environments, and enables real-time structural health monitoring.

Various arrangements have been described, each of which comprises one or more combinations of features. It will be appreciated by those skilled in the art that, except where clearly mutually exclusive, any of the features may be employed separately or in combination with any other features.

## Claims

1. A component manufactured by an additive manufacturing process, the component comprising conductive (34, 44, 54) and non-conductive (30, 40, 50) elements, the conductive and non-conductive elements cooperating to form a capacitor which in use responds to an external stimulus (36, 46).

2. The component of claim 1, in which the conductive and non-conductive elements form a cell (32, 42) in a lattice.

3. The component of claim 2, in which the cell contributes to the mechanical strength of the component.

4. The component of claim 1, in which the capacitor comprises two spaced-apart conductive elements (34), and in which the capacitor responds to the external stimulus by a change in the distance between the conductive elements.

5. The component of claim 1, in which the capacitor comprises two spaced-apart conductive elements (44), and in which the capacitor responds to the external stimulus by a change in the area of overlap between the conductive elements.

6. The component of claim 1, in which the external stimulus is one selected from the list comprising: vibration; acceleration; moisture level; deformation.

7. The component of claim 2, in which the cell comprises a centre cell wall, and in which the centre cell wall (54B) acts in use as a beam-mass structure (60, 160, 360).

8. The component of claim 7, in which the first resonance mode of the beam-mass structure (160) is a twisting mode.

9. The component of claim 8, in which the conductive elements (388) forming the capacitor are curved.

10. The component of claim 1, further comprising integrated conduction paths (490) manufactured by an additive manufacture process.

11. A component manufactured by an additive manufacturing process, the component comprising conductive and non-conductive (704, 714) elements, the component comprising a plurality of conduction channels (706, 716, 720), the conduction channels arranged so that in use their electrical properties will change in response to damage (708, 718) within the component.

12. The component of claim 11, in which the plurality of conduction channels is arranged in a 3-dimensional lattice, and in which a change in the electrical properties of two or more adjacent conduction channels (720) will permit the location of damage (718) to be determined.

13. A method of manufacturing a component by an additive manufacturing process, the method comprising disposing conductive (34, 44, 54) and non-conductive (30, 40, 50) elements to form a capacitor which in use can respond to an external stimulus (36, 46).

14. A method of manufacturing a component by an additive manufacturing process, the method comprising disposing conductive and non-conductive (704, 714) elements to form a plurality of conduction channels (706, 716, 720), the conduction channels arranged so that in use their electrical properties will change in response to damage (708, 718) within the component.

15. The method of claim 14, in which the plurality of conduction channels is arranged in a 3-dimensional lattice, so that in use a change in the electrical properties of two or more adjacent conduction channels (720) will permit the location of damage (718) to be determined.
